# EUROPÄISCHE PATENTSCHRIFT

(11) **EP 2 287 938 B1**
(45) Veröffentlichungstag und Bekanntmachung des Hinweises auf die Patenterteilung: **01.08.2012**
(21) Anmeldenummer: 09010783.0
(22) Anmeldetag: 22.08.2009
(51) Int. Cl.: H01L 51/50, H01L 51/52

(54) **Ladungsträger-Transportschicht, Verfahren zu ihrer Herstellung und elektrooptisches Bauelement**
Charge carrier transport layer, method for production of same and electro-optical construction element
Couche de transport d'un support de charge, son procédé de fabrication et composant électro-optique

(43) Veröffentlichungstag der Anmeldung: 23.02.2011
(73) Patentinhaber: Karlsruher Institut für Technologie, 76131 Karlsruhe (DE)
(72) Erfinder: Lemmer, Ulrich, 76228 Karlsruhe (DE); Hauss, Julian, 76131 Karlsruhe (DE); Riedel, Boris, 76131 Karlsruhe (DE); Gerken, Martina, 24116 Kiel (DE)

(56) Entgegenhaltungen:
- US-A1- 2007 176 174
- US-A1- 2008 135 809
- SEOK-JOO WANG ET AL: "Study of PEDOT:PSS-SnO2 nanocomposite film as an anode for polymer electronics" JOURNAL OF ELECTROCERAMICS, KLUWER ACADEMIC PUBLISHERS, BO, Bd. 18, Nr. 1-2, 22. Februar 2007 (2007-02-22), Seiten 161-165, XP019502648 ISSN: 1573-8663
- CHOY W C H ET AL: "Improving the viewing angle properties of microcavity OLEDs by using dispersive gratings" OPTICS EXPRESS 20071001 OPTICAL SOCIETY OF AMERICA US, Bd. 15, Nr. 20, 28. September 2007 (2007-09-28), Seiten 13288-13294, XP7910669
- BATHELT ET AL: "Light extraction from OLEDs for lighting applications through light scattering" ORGANIC ELECTRONICS, ELSEVIER, AMSTERDAM, NL, Bd. 8, Nr. 4, 16. Mai 2007 (2007-05-16), Seiten 293-299, XP022080892 ISSN: 1566-1199

## Beschreibung

Die Erfindung betrifft eine Ladungsträger-Transportschicht für ein elektrooptisches Bauelement, ein Verfahren zu ihrer Herstellung und ein elektrooptisches Bauelement, in das die erfindungsgemäße Ladungsträger-Transportschicht eingebracht ist, vorzugsweise eine organische Leuchtdiode (OLED) oder eine organische Solarzelle.

Transparente Ladungsträger-Transportschichten, d.h. Transportschichten für Elektronen bzw. Löcher spielen eine zentrale Rolle in vielen Anwendungen in der großflächigen Optoelektronik, insbesondere in Displays, Touchpads oder Solarzellen. Die Ladungsträger-Transportschichten enthalten zunehmend organische Materialien, vor allem in organischen Leuchtdioden (OLEDs) und organischen Solarzellen. Der Vorteil organischer Materialien, insbesondere von Polymeren, liegt darin, dass sich diese aus der flüssigen Phase prozessieren lassen und somit die großflächige, vakuumfreie und damit kostengünstige Herstellung von elektrooptischen Elementen ermöglichen.

In strahlungsemittierenden Bauelementen, insbesondere organische Leuchtdioden (OLEDs), finden sich in der Regel eine Loch-Transportschicht und häufig auch eine Elektronen-Transportschicht. Trotz einer internen Quanteneffizienz von bis zu 100 % für die Umwandlung von Elektron-Loch-Paaren in Photonen gelangen aufgrund von Totalreflexion innerhalb des strahlungsemittierenden Bauelements ohne weitere Maßnahmen nur ca. 20 % des Lichts nach außen, die einer Nutzung zugeführt werden können.

Aus der GB 2 426 627 A ist ein strahlungsemittierendes Bauelement bekannt, das eine lichtabsorbierende Schicht enthält, in die metallische nanokristalline Partikel von einer mittleren Größe von 2 nm bis 20 nm in eine Matrix eingebracht sind.

Die DE 101 64 016 A1 offenbart eine organische Leuchtdiode (O-LED) mit einer organischen Ladungsträger-Transportschicht, die mindestens zwei Teilbereiche aufweist, die sich in ihrem Brechungsindex unterscheiden. Hierbei werden die mindestens zwei Teilbereiche aus verschiedenen Polymeren gebildet, die aufgrund unterschiedlicher Vernetzungsgrade, Verzweigungsgrade, Dichten oder Co-Polymerisationen der verschiedenen Polymere eine kompositartige Struktur ausbilden.

Die DE 10 2007 006 348 A1 offenbart ein strahlungsemittierendes Bauelement, das ein Substrat oder eine hieran in Bezug auf die Emitterschicht nach außen an das Substrat angrenzende Schicht enthält, in die Streupartikel mit einer Größe von 1 nm bis 10 µm eingebracht sind. Als Streupartikel werden Nanopartikel aus Gold, Silber, Platin, Nickel, Kupfer oder Polystyrol eingesetzt, wobei die Streupartikel bevorzugt einen Kernbereich und eine Hülle aufweisen.

Aus der US 2007/0176174 A1 ist ein leitfähiges Polymer für elektrooptische Vorrichtungen bekannt, das SiO₂- oder TiO₂-Nanopartikel mit Durchmessern von 5-100 nm umfasst. Als leitfähiges Polymer wird bevorzugt ein PEDOT:PSS-Derivat eingesetzt.

Die US 2008/135809 A1 offenbart leitfähige Polymere für OLEDs, wobei die leitfähigen Polymere PANI oder PEDOT umfassen, worin Nanopartikel, insbesondere SiO₂- oder Nafion-Nanopartikel mit einer Größe unterhalb von 1000 nm eingelagert sind.

Ausgehend hiervon ist es die Aufgabe der vorliegenden Erfindung, eine Ladungsträger-Transportschicht für ein elektrooptisches Bauelement, ein Verfahren zu ihrer Herstellung und ein elektrooptisches Bauelement, in das eine erfindungsgemäße Ladungsträger-Transportschicht eingebracht ist, vorzuschlagen, die die vorher genannten Nachteile und Einschränkungen nicht aufweisen.

Insbesondere soll eine Ladungsträger-Transportschicht bereitgestellt werden, in der sich die Schichtdicke und der effektive Brechungsindex im Hinblick auf das Streuverhalten der Photonen einstellen lassen, wobei eine derartige Schicht trotz höherer Streuwirkung kaum an Transparenz und elektrischer Leitfähigkeit einbüßen soll.

Weiterhin soll ein hierfür besonders angepasstes und einfach durchzuführendes Herstellungsverfahren vorgeschlagen werden.

Schließlich soll ein elektrooptisches Bauelement angegeben werden, in das eine erfindungsgemäße Ladungsträger-Transportschicht eingebracht ist.

Diese Aufgabe wird gelöst im Hinblick auf die Ladungsträger-Transportschicht durch die Merkmale des Anspruchs 1, im Hinblick auf das Herstellungsverfahren durch die Schritte des Anspruchs 5 und im Hinblick auf das elektrooptische Bauelement durch die Merkmale des Anspruchs 7. Die Unteransprüche beschreiben jeweils vorteilhafte Ausgestaltungen.

Eine erfindungsgemäße Ladungsträger-Transportschicht enthält ein organisches Ladungsträger-Transportmaterial, vorzugsweise die kationische Form des Polymers Poly(3,4-Ethylendioxythiophen) mit Polystyrolsulfonsäure, üblicherweise kurz als PEDOT:PSS bezeichnet, oder Polyanilin.

In das vorliegende organische Ladungsträger-Transportmaterial sind eine Vielzahl von ersten Partikeln (Nanopartikeln), die einen Durchmesser von 1 nm bis 100 nm aufweisen, eingebracht. Weiterhin sind in das organische Ladungsträger-Transportmaterial eine Vielzahl von zweiten Partikeln, die einen Durchmesser zwischen 100 nm und 1000 nm besitzen, oder aus hieraus gebildeten Agglomeraten eingebracht. Aufgrund ihrer Größe ist es entscheidend, dass sich der Brechungsindex der zweiten Partikeln vom Brechungsindex des organischen Materials unterscheidet.

Die Ladungsträger-Transportschicht besitzt vorzugsweise eine Schichtdicke von 100 nm bis 1000 nm, wobei die Schichtdicke jedoch nicht geringer als die jeweiligen Durchmesser der zweiten Partikel bzw. den hieraus gebildeten Agglomeraten sein kann.

In der Ladungsträger-Transportschicht sind erste Partikel enthalten, die ganz oder teilweise aus einem transparenten Oxid, insbesondere aus Siliziumdioxid, bestehen.

In der Ladungsträger-Transportschicht sind zweite Partikel enthalten, die ganz oder teilweise aus dem transparenten Oxid Titandioxid, bestehen. Die zweiten Partikel bilden bevorzugt Agglomerate aus, können jedoch auch vereinzelt in der Ladungsträger-Transportschicht auftreten.

Die zweiten Partikel selbst können massiv oder hohl sein. Hohle Partikel lassen sich herstellen, indem eine Vielzahl von Partikeln aus einem Polymer wie Polystyrol mit dem Oxid beschichtet und anschließend das Polymer durch thermisches Verbrennen beseitigt wird.

Eine erfindungsgemäße Ladungsträger-Transportschicht lässt sich vorzugsweise mit dem folgenden Verfahren herstellen. Hierzu werden die ausgewählten ersten und ggf. zweiten Partikel mit dem für die Ladungsträger-Transportschicht vorgesehenen organischen Material, bevorzugt PEDOT:PSS oder Polyanilin, in einem gemeinsamen Lösungsmittel dispergiert und dann auf ein Substrat, vorzugsweise durch ein Beschichtungsverfahren, durch ein Aufschleuderverfahren (*spin coating*) oder durch Rakeln, aufgebracht. Durch Wahl der Zusammensetzung und Konzentration der Partikel sowie der Dicke der Ladungsträger-Transportschicht ist es möglich, den effektiven Brechungsindex einer Wellenleitermode in einem elektrooptischen Bauelement, in das eine Ladungsträger-Transportschicht eingebracht ist, einzustellen.

Insbesondere durch die Festlegung der Schichtdicke der Ladungsträger-Transportschicht, die durch die Einmischung der Partikeln zunimmt, lässt sich in einem elektrooptischen Bauelement nicht nur eine optimierte Modenverteilung einstellen, sondern auch gleichzeitig die Lichtauskopplungseffizienz bei organischen Leuchtdioden (OLEDs) bzw. die Lichteinkopplungseffizienz bei organischen Solarzellen erhöhen. Während die ersten Partikel den Wert des effektiven Brechungsindex in der Ladungsträger-Transportschicht beeinflussen, wirken die zweiten Partikel bzw. die hieraus gebildeten Agglomerate als optische Streuzentren, die den Anteil des Lichts, das als Wellenleitermode durch eine erfindungsgemäße Ladungsträger-Transportschicht geführt wird, effektiv aus dem Bauteil herausstreuen (OLEDs) bzw. einkoppeln (Solarzellen). Bei gleich bleibender Schichtdicke der Ladungsträger-Transportschicht und derselben Konzentration an ersten und zweiten Partikeln wird darüber hinaus der effektive Brechungsindex der Lochtransport-Schicht durch die Wanddicken von hohlen Partikeln beeinflusst.

Die Erfindung betrifft schließlich ein elektrooptisches Bauelement, in das die erfindungsgemäße Ladungsträger-Transportschicht eingebracht ist, insbesondere eine organische Leuchtdiode (OLED) oder eine organische Solarzelle.

So kann in einer OLED eine jeweils geeignet ausgestaltete erfindungsgemäße Ladungsträger-Transportschicht als Loch-Transportschicht, als Elektronen-Transportschicht, als Anode und/ oder als Kathode eingesetzt werden. Insbesondere bei der Verwendung als Anode wird die erfindungsgemäße Ladungsträger-Transportschicht zur Erhöhung der lateralen Leitfähigkeit vorzugsweise mit Dimethylsulfoxid (DMSO) versetzt und ersetzt eine Anode aus Indiumzinnoxid (*indium tin oxide*, ITO).

In einer besonderen Ausgestaltung wird die erfindungsgemäße Ladungsträger-Transportschicht (Loch- bzw. Elektronen-Transportschicht) dazu verwendet, um raue Anoden oder Kathoden zu glätten bzw. einen bestehenden Höhenunterschied auf der Oberfläche einer Schicht auszugleichen, insbesondere um etwaige Kurzschlüsse zu vermeiden.

Elektrooptische Bauelemente mit einer oder mehreren erfindungsgemäßen Ladungsträger-Transportschichten lassen sich in einer Vielzahl von Anwendungen wie Displays, Touchpads oder Touchscreen-Displays einsetzen.

Der wesentliche Vorteil einer erfindungsgemäßen Ladungsträger-Transportschicht liegt - im Gegensatz zu einer herkömmlichen Ladungsträger-Transportschicht - darin, dass die erfindungsgemäße Schicht eine bis zu 2- bis 10-fach dickere Streuschicht aufweisen kann, während sie hierbei jedoch kaum an Transparenz und elektrischer Leitfähigkeit einbüßt.

Die Erfindung wird im Folgenden anhand von Ausführungsbeispielen mit Hilfe der Abbildungen näher erläutert. Es zeigen:
- **Fig. 1**: Schematische Darstellung des Aufbaus einer OLED mit ei- ner erfindungsgemäßen Ladungsträger-Transportschicht als Loch-Transportschicht;
- **Fig. 2**: Winkelaufgelöstes Streuverhalten bei Bestrahlung mit einer Wellenlänge λ = 532 nm;
- **Fig. 3**: Leuchtdichte in cd/m² gegen eine an eine OLED angelegte äußere Spannung in Volt.

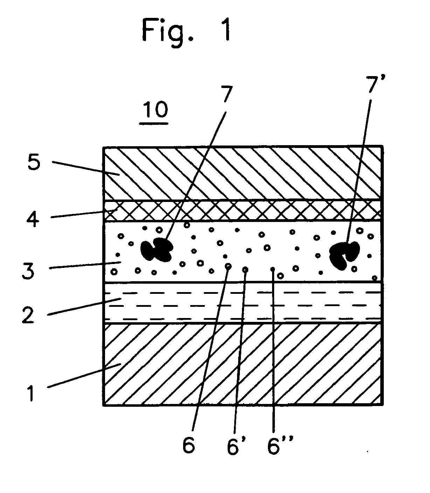

**Fig. 1** zeigt schematisch den Aufbau einer organischen Leuchtdiode (OLED) **10,** die eine erfindungsgemäße Loch-Transportschicht **3** besitzt. Auf ein für große Bereiche des optischen Spektrums, d.h. vom Ultraviolett über den sichtbaren Bereich bis hin zum Infrarot, transparentes Substrat **1,** das bevorzugt aus Glas oder einem transparenten Kunststoff besteht, ist eine transparente Anode **2** angeordnet, die aus Indiumzinnoxid (*indium tin* oxide, ITO) besteht.

Auf der gegenüberliegenden Seite der OLED **10** befindet sich eine Kathode **5** aus einem leitfähigen Material, das vorzugsweise eine geringe Austrittsarbeit für die Elektronen besitzt, besonders bevorzugt Calcium oder Magnesium, und die hier in direktem Kontakt mit einer organischen Emitterschicht **4,** d.h. einer zur Emission einer optischen Strahlung ausgebildeten Schicht, steht, wofür hier ein phenylensubstituiertes Poly(p-Phenylen-Vinylen) (PPV) eingesetzt wurde. Alternativ ist zwischen der Kathode **5** und der organischen Emitterschicht **4** eine Elektronen-Transportschicht eingefügt.

Zwischen der Anode **2** und der Emitterschicht **4** befindet sich eine Lochtransport-Schicht **3,** die zur Absenkung der Injektionsbarriere für die Löcher aus der Anode **2** dient und die gleichzeitig die Eindiffusion von Material, insbesondere von Indium, aus der Anode **2** in die Emitterschicht **4** verhindert.

Die Lochtransport-Schicht **3** weist das organische Material PE-DOT:PSS auf, in das sowohl eine Vielzahl von ersten Partikeln **6, 6', 6",** ... als auch eine Vielzahl von aus zweiten Partikeln gebildeten Agglomeraten **7, 7'** eingelagert sind, wobei sich der Brechungsindex der zweiten Partikel vom Brechungsindex des organischen Materials unterscheidet.

Als beispielhafte Materialien wurden die wie folgt bezeichneten Proben aus Partikelmischungen für die Lochtransport-Schicht **3** eingesetzt:
**LH2O13-3000:** Mischung aus 23,5 Vol.% SiO₂-Partikeln (fertige Dispersion, Größe 20 nm bis 30 nm), 47,65 Vol.% H₂O, und 50 Vol.% PEDOT:PSS, die durch Aufschleudern bei 3000 U/min auf die transparente Anode **2** aufgebracht wurde.
**TL11-1000:** Mischung aus 0,925 Vol.% TiO₂ (wässrige Dispersion, Größe von 20 nm bis 130 nm), 4,705 Vol.% SiO₂ (fertige Dispersion, Größe 20 nm bis 30 nm), 44,37 Vol.% H₂O und 50 Vol.% PE-DOT:PSS, aufgebracht durch Aufschleudern bei 1000 U/min.
**TL21-1000:** Mischung aus 1,23 Vol.% TiO₂ (wässrige Dispersion, Größe 20 nm bis 130 nm), 3,14 Vol.% SiO₂ (fertige Dispersion, Größe 20 nm bis 30 nm), 45,63 Vol.% H₂O und 50 Vol.% PEDOT:PSS, aufgebracht durch Aufschleudern bei 1000 U/min.

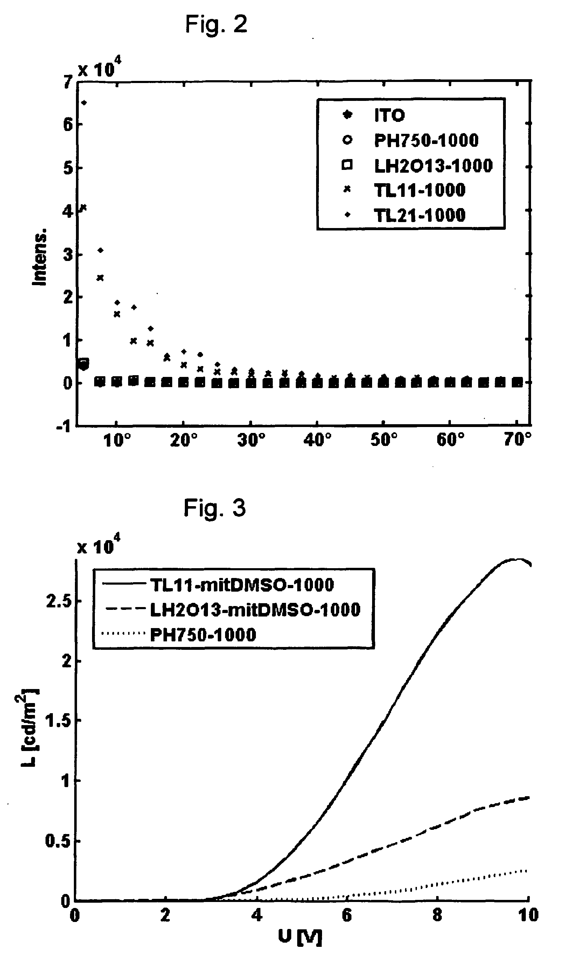

**Fig. 2** zeigt das winkelaufgelöste Streuverhalten von Lochtransport-Schichten **3,** die sich jeweils auf einer auf einem Substrat **1** aufgebrachten transparenten Anode **2** befanden und die die jeweils bezeichneten Partikelmischungen enthielten. Die betreffenden Schichten wurden hierzu mit einem Laser, der Licht einer Wellenlänge λ = 532 nm emittierte, durchleuchtet, und der Streupunkt wurde winkelaufgelöst aufgenommen.

Die mit PH750-1000 bezeichnete Probe diente als Vergleichsversuch, da sie weder erste Partikel noch zweite Partikel, sondern ausschließlich PEDOT:PSS enthielt. Als weiterer Vergleichsversuch wurde schließlich eine mit ITO bezeichnete Probe eingesetzt, die keine Lochtransport-Schicht **3** enthielt, sondern in der lediglich auf einem Substrat **1** eine transparente Anode **2** aus Indiumzinnoxid (*indium tin oxide,* ITO) aufgebracht worden war. Hieraus ist die starke Zunahme der Streuung in Proben, die eine erfindungsgemäße Lochtransport-Schicht enthielten, bei kleinen Winkeln erkennbar.

**Fig. 3** zeigt die Leuchtdichten in cd/m² gegen die an organischen Leuchtdioden (OLEDs) **10,** die jeweils eine erfindungsgemäße Loch-Transportschicht **3** aufwiesen, angelegten äußeren Spannungen in Volt. Hierzu wurde in den beiden Proben TL11-mitDMSO-1000 und LH2O13-mitDMSO-100 anstelle von reinem PE-DOT:PSS eine Mischung aus 95 Vol.% PEDOT:PSS und 5 Vol.% Dimethylsulfoxid (DMSO) beigemischt.

DMSO wird zu PEDOT:PSS üblicherweise beigemischt, um die laterale Leitfähigkeit zu erhöhen. Im vorliegenden Fall diente das Beimischen von DMSO dazu, um auch die vertikale Leitfähigkeit zu erhöhen, damit über die Partikeln enthaltenden erfindungsgemäßen Lochtransport-Schichten **3** eine geringere Spannung abfällt.

Die mit PH750-1000 bezeichnete Probe diente als Vergleichsversuch und enthielt daher weder erste Partikel noch zweite Partikel, sondern ausschließlich PEDOT:PSS.

**Fig. 3** zeigt, dass die die Leuchtdichten einer OLED, die eine erfindungsgemäße Lochtransport-Schicht enthielt, im Unterschied zur Vergleichsprobe deutlich erhöht war.

## Patentansprüche

1. Ladungsträger-Transportschicht (3) für ein elektrooptisches Bauelement, umfassend ein organisches Ladungsträger-Transportmaterial, in welchem eine Vielzahl von ersten Partikeln (6, 6', 6", ...) mit einem Durchmesser von 1 nm bis 100 nm eingelagert ist, wobei die ersten Partikeln (6, 6', 6", ...) ein transparentes Oxid enthalten,
**dadurch gekennzeichnet, dass** in das organische Ladungsträger-Transportmaterial weiterhin eine Vielzahl von zweiten Partikeln, die transparentes Titandioxid enthalten, mit einem Durchmesser zwischen 100 nm und 1000 nm oder hieraus gebildeten Agglomerate (7, 7') eingelagert ist, deren Brechungsindex sich vom Brechungsindex des organischen Ladungsträger-Transportmaterials unterscheidet.

2. Ladungsträger-Transportschicht (3) nach Anspruch 1, **dadurch gekennzeichnet, dass** die Ladungsträger-Transportschicht (3) eine Schichtdicke von 100 nm bis 1000 nm aufweist, wobei die Schichtdicke zumindest den Durchmessern der zweiten Partikeln oder den hieraus gebildete Agglomeraten (7, 7') entspricht.

3. Ladungsträger-Transportschicht (3) nach Anspruch 1 oder 2, **dadurch gekennzeichnet, dass** die ersten Partikel Siliziumdioxid enthalten.

4. Ladungsträger-Transportschicht (3) nach einem der Ansprüche 1 bis 3, **dadurch gekennzeichnet, dass** die Ladungsträger-Transportschicht (3) PEDOT:PSS (Poly-3,4-ethylendioxythiophen mit Polystyrolsulfonsäure) oder Polyanilin als organisches Ladungsträger-Transportmaterial enthält.

5. Verfahren zur Herstellung einer Ladungsträger-Transportschicht (3) für ein elektrooptisches Bauelement nach einem der Ansprüche 1 bis 4, **dadurch gekennzeichnet, dass** die ersten Partikel zusammen mit dem für die Ladungsträger-Transportschicht (3) vorgesehenen organischen Material in einem gemeinsamen Lösungsmittel dispergiert und anschließend auf ein Substrat aufgebracht werden.

6. Verfahren nach Anspruch 5, **dadurch gekennzeichnet, dass** die ersten Partikel und die zweiten Partikel zusammen mit dem für die Ladungsträger-Transportschicht (3) vorgesehenen organischen Material in einem gemeinsamen Lösungsmittel dispergiert und anschließend auf ein Substrat aufgebracht werden.

7. Elektrooptisches Bauelement (10), in das eine Ladungsträger-Transport-Schicht (3) gemäß einem der Ansprüche 1 bis 4 eingebracht ist.

8. Elektrooptisches Bauelement (10) nach Anspruch 7, das als organische Leuchtdiode (OLED) oder als organische Solarzelle ausgebildet ist.

## Claims

1. Charge carrier transport layer (3) for an electro-optical component, comprising an organic charge carrier transport material in which is embedded a plurality of first particles (6, 6', 6", ...) with a diameter from 1 nm to 100 nm, wherein the first particles (6, 6', 6", ...) contain a transparent oxide, **characterised in that** in the organic charge carrier transport material is further embedded a plurality of second particles containing transparent titanium dioxide and with a diameter between 100 nm and 1000 nm or agglomerates (7, 7') formed therefrom, the refractive index of which differs from the refractive index of the organic charge carrier transport material.

2. Charge carrier transport layer (3) according to claim 1, **characterised in that** the charge carrier transport layer (3) has a layer thickness between 100 nm and 1000 nm, wherein the layer thickness corresponds at least to the diameters of the second particles or the agglomerates (7, 7') formed therefrom.

3. Charge carrier transport layer (3) according to claim 1 or 2, **characterised in that** the first particles contain silicon dioxide.

4. Charge carrier transport layer (3) according to any of claims 1 to 3, **characterised in that** the charge carrier transport layer (3) contains PEDOT:PSS (poly-3,4-ethylenedioxythiophene with polystyrolsulfonic acid) or polyaniline as an organic charge carrier transport material.

5. Method for production of a charge carrier transport layer (3) for an electro-optical component according to any of claims 1 to 4, **characterised in that** the first particles together with the organic material provided for the charge carrier transport layer (3) are dispersed in a common solvent and then applied to a substrate.

6. Method according to claim 5, **characterised in that** the first particles and the second particles together with the organic material provided for the charge carrier transport layer (3) are dispersed in a common solvent and then applied to a substrate.

7. Electro-optical component (10) in which is incorporated a charge carrier transport layer (3) according to any of claims 1 to 4.

8. Electro-optical component (10) according to claim 7, which is formed as an organic light emitting diode (OLED) or an organic solar cell.

## Revendications

1. Couche de transport d'un support de charge (3) d'un composant optoélectronique comportant un matériau de transport organique de support de charge contenant un grand nombre de premières particules (6, 6', 6", ...) d'un diamètre compris entre 1 nm et 100 nm, * les premières particules (6, 6', 6", ...) contenant un oxyde transparent,
couche **caractérisée en ce que**
la matière organique de transport de support de charge comporte en outre un grand nombre de secondes particules contenant du dioxyde de titane transparent, ces particules ayant un diamètre compris entre 100 nm et 1000 nm ou des agglomérations (7, 7') constituées de telles particules et dont l'indice de réfraction diffère de l'indice de réfraction de la matière organique de transport de charge du support de charge.

2. Couche de transport de support de charge (3) selon la revendication 1,
**caractérisée en ce que**
la couche (3) a une épaisseur comprise entre 100 nm et 1000 nm et cette épaisseur correspond au moins au diamètre des secondes particules ou des agglomérations (7, 7') formées avec celles-ci.

3. Couche de transport de support de charge (3) selon la revendication 1 ou 2,
**caractérisée en ce que**
les premières particules comportent du dioxyde de silicium.

4. Couche de transport de support de charge (3) selon l'une des revendications 1 à 3,
**caractérisée en ce que**
la couche de transport de support de charge (3) contient du PEDOT: PSS mélange de poly(3,4-éthylènedioxythiophène) et de poly(styrène sulfonate) ou de la polyaniline comme matière organique de transport de support de charge.

5. Procédé de fabrication d'une couche de transport de support de charge (3) pour un composant optoélectronique selon l'une des revendications 1 à 4,
**caractérisé en ce que**
les premières particules et la matière organique prévue pour la couche de transport (3) de support de charge, sont dispersées dans un solvant commun et sont ensuite appliquées sur un substrat.

6. Procédé selon la revendication5,
**caractérisé en ce que**
les premières particules et les secondes particules sont dispersées avec la matière organique prévue pour la couche de transport de support de charge (3), dans un solvant commun et sont ensuite appliquées sur un substrat.

7. Composant optoélectronique (10) dans lequel la couche de transport de support de charge (3) est réalisée selon l'une des revendications 1 à 4.

8. Composant optoélectronique (10) selon la revendication 7,
**caractérisé en ce qu'**
il est réalisé comme photodiode organique (OLED) ou comme cellule solaire organique.
